# EUROPÄISCHE PATENTSCHRIFT

(11) **EP 0 889 595 B1**
(45) Veröffentlichungstag und Bekanntmachung des Hinweises auf die Patenterteilung: **19.03.2003**
(21) Anmeldenummer: 98110702.2
(22) Anmeldetag: 10.06.1998
(51) Int. Cl.: H03L 7/18, H04L 27/20

(54) **Hochfrequenz-Signalgenerator**
High-frequency signal generator
Générateur de signaux haute fréquence

(30) Priorität: 30.06.1997 DE 19727810
(43) Veröffentlichungstag der Anmeldung: 07.01.1999
(73) Patentinhaber: Infineon Technologies AG, 81669 München (DE)
(72) Erfinder: Kranz, Christian, 40885 Ratingen Lintorf (DE)
(74) Vertreter: Epping Hermann & Fischer

(56) Entgegenhaltungen:
- EP-A- 0 499 245
- US-A- 5 351 014
- US-A- 5 444 420

## Beschreibung

Die Erfindung betrifft einen Hochfrequenz-Signalgenerator. Dieser dient zur Erzeugung von Hochfrequenz-Signalen für digitale Kommunikationsgeräte mit kontinuierlicher Phasenmodulation (Continious Phase Modulation).

In Geräten, die digitale Informationen über elektromagnetische Wellen austauschen, werden hochfrequente Signale benötigt. Die Information wird über geeignete Modulationsverfahren den hochfrequenten Signalen aufmoduliert.

Bei Schnurlostelefonen nach dem DECT-Standard wird ein digitaler Bitstrom mit einer Bitrate von 1152 kbit/s als Informationssignal, im folgenden auch als Eingangssignal bezeichnet, erzeugt. Die Abkürzung DECT steht für Digital Enhanced Cordless Telephone. Ein DECT-Netz ist ein mikrozellulares, digitales Mobilfunknetz für hohe Teilnehmerdichten. Im DECT-Standard werden die folgenden Schichten spezifiziert: Physikalische Schicht (Physical Layer), Mittlere Zugriffssteuerungsebene (Medium Access Control Layer), Datenverbindungskontrolle (Data Link Control Layer) und Netzwerkschicht (Network Layer). Weiterhin beschreibt der DECT-Standard eine Transportschicht (Transport Layer), eine Kommunikationssteuerung (Session Layer), eine Darstellungsschicht (Presentation Layer) und eine Verarbeitungsschicht (Application Layer). Die physikalische Schicht unterteilt das Funkspektrum in physikalische Kanäle. Neben Zeit und Frequenz stehen die Dimensionen Raum und Code zur Verfügung. Es wird ein TDMA-Verfahren (Time Devision Multible Access) bei 10 Trägerfrequenzen verwendet. Diese liegen im Frequenzband von 1880 bis 1900 MHz. Auf jeder Trägerfrequenz besitzt die TDMA-Struktur 10 ms lange Rahmen (Frames), die jeweils 24 Zeitschlitze (Slots) enthalten. Ein Rahmen wird alle 10 ms für 470 µs ausgesendet. Damit ergibt sich ein Bitstrom mit einer Bruttodatenrate von 1152 kbit pro Sekunde. Der Trägersignalabstand beträgt 1,728 MHz.

Aus S. Heinen, "An integrated bipolar transmitter for DECT", 1997 IEEE ist bekannt, daß der Sender im wesentlichen aus einer Nachlaufsynchronisation besteht, im folgenden als Phase-Locked-Loop (PLL) bezeichnet, bei einer Endstufe und einem Signalformer für das digitale Eingangssignal. Im Zeitabschnitt vor dem Sendeintervall schwingt die PLL auf eine Nennfrequenz ein, mit dem Beginn des Sendens wird die Regelschleife geöffnet und der spannungsgesteuerte Oszillator, auch als Voltage Controlled Oszillator (VCO) bezeichnet, wird mit dem geformten Digitalsignal moduliert. Das Ausgangssignal des VCO's wird in der Endstufe verstärkt und durch eine Antenne ausgesendet. Beim Empfangen wird mit der PLL ein Hochfrequenz-Signal zum Mischen des Eingangssignals gebildet. Dabei wird der Regelkreis des VCO's nicht geöffnet. Sämtliche Komponenten dieser Schaltung, ausgenommen die Teiler der PLL, sind analog ausgeführt. Eine Hochintegration in einen digitalen CMOS-Prozeß ist nicht möglich.

Dokument US 5 351 014 zeigt eine PLL, bei der die Teiler durch Akkumulatoren ersetzt sind.

Die Aufgabe der Erfindung ist es einen Hochfrequenz-Signalgenerator anzugeben, der weitestgehend digitale Komponenten enthält, um eine Hochintegration in einem digitalen CMOS-Prozeß zu ermöglichen.

Vorteilhafterweise kann die Schaltung dadurch kostengünstiger realisiert werden. Weiterhin kann das analoge Schleifenfilter (Loop-Filter) der PLL dadurch eingespart werden.

Vorteilhafte Weiterbildungen ergeben sich aus den abhängigen Ansprüchen.

So hat die Weiterbildung gemäß Anspruch 4 den Vorteil, daß durch die feste Einstellung des Frequenzteilerverhältnisses Steuersignale und der Aufwand für einen programmierbaren Teiler entfallen, der üblicherweise in solchen Systemen eingesetzt wird.

Dadurch daß nach Einschalten des VCO's das Analogsignal des Digital-Analog-Wandlers konstant gehalten wird, d.h. der Digital-Analog-Wandler wird eingefroren, können im Empfangssignal Störungen durch Quantisierungsfehler des Digital-Analog-Wandlers unterdrückt werden. Damit erhält der VCO eine konstante Eingangsspannung. Das Phasenrauschen des Hochfrequenz-Signals hängt im wesentlichen nur noch vom VCO und von Störungseinkopplungen ab.

Indem das erste digitale Filter zeitabhängig adaptiv ausgeführt ist, läßt sich eine erhebliche Verkürzung der Einschwingzeit der Regelschleife erreichen. Das ist besonders für sogenannte Fast-Hopping-Systeme interessant, bei denen innerhalb sehr kurzer Zeit die Trägerfrequenz gewechselt werden muß.

Vorteilhafterweise wird das analoge Filter als Dezimationsfilter mit gleichzeitiger Überabtastung durch den Digital-Analog-Wandler ausgeführt. Dadurch können Anforderungen an die Genauigkeit des Digital-Analog-Wandlers reduziert werden. Ein weiteres digitales Filter kann zwischen den Summierer und den Digital-Analog-Wandler eingefügt werden.

Die Erfindung wird im folgenden anhand einer Figur weiter erläutert.

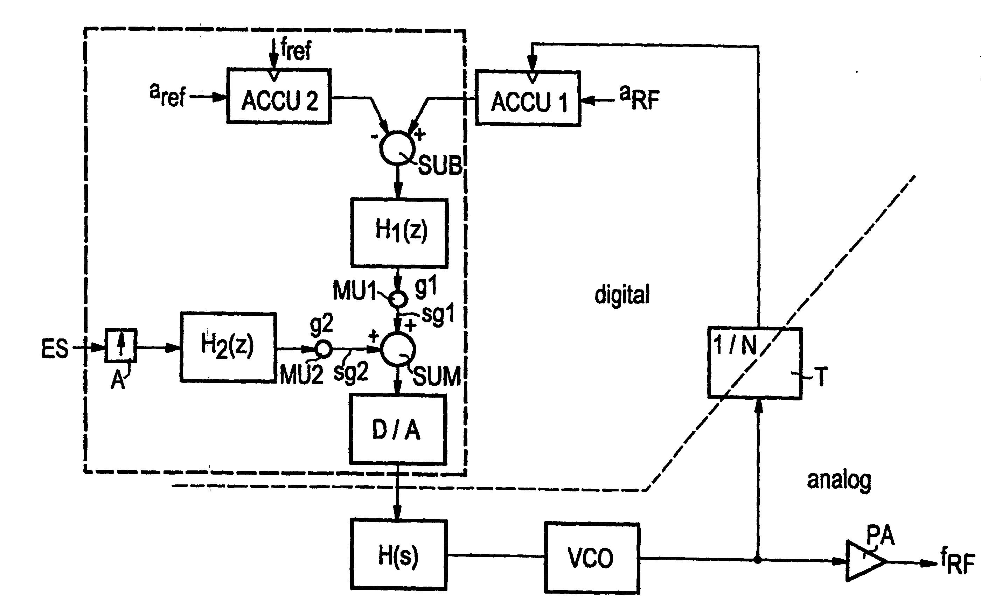

Die Figur zeigt das Blockschaltbild der erfindungsgemäßen Schaltung.

Das gewünschte Hochfrequenz-Signal mit der Frequenz fRF wird durch einen Voltage-Controlled-Oszillator VCO erzeugt und über eine Endstufe PA an eine Antenne geleitet. Ein digitaler 1/N-Teiler T generiert den Takt für einen ersten Akkumulator ACCU1, welcher mit jedem Takt das digitale Signal aRF aufaddiert. Ein zweiter Akkumulator ACCU2 addiert mit einem Referenztakt (Taktfrequenz fref) das digitale Signal aref auf. Beide Akkumulatorausgangssignale werden auf einen Subtrahierer SUB geführt. Dessen Ausgangssignal wird mittels eines digitalen Filter H1(z) gefiltert und mit einem Gewichtungsfaktor g1 multipliziert. Hierzu ist ein erster Multiplizierer MU1 vorgesehen. Dessen Ausgangssignal wird als erstes gewichtetes Filterausgangssignal Sg1 bezeichnet. Dieses erste gewichtete Filterausgangssignal Sg1 liegt am einen Eingang eines Summierers SUM an. Am anderen Eingang des Summierers SUM liegt das mittels einer Abtasteinrichtung A überabgetastete, einem zweiten digitalen Filter H2(z) digital gefilterte und anschließend einem zweiten Multiplizierer MU2 mit dem Gewichtungsfaktor g2 multiplizierte Eingangssignal ES (Eingangsbitstrom) an. Ein Digital-Analog-Wandler D/A generiert aus dem vom Summierer SUM stammenden Summationssignal ein proportionales analoges Signal. Dieses Signal wird mit einem analogen Filter H(s) analog gefiltert und steuert den spannungsgesteuerten Oszillator VCO.

Die Trägerfrequenz wird durch geeignete Wahl der digitalen Signale aRF und aref eingestellt. Die Stabilität bzw. das Einschwingverhalten der Schaltung läßt sich durch den Gewichtungsfaktor g1 und die Modulationsamplitude durch den Gewichtungsfaktor g2 einstellen.

Zusätzlich besteht die Möglichkeit, zwischen dem Summierer SUM und dem Digital-Analog-Wandler D/A ein drittes digitales Filter vorzusehen. Diese Ausgestaltung der Erfindung ist in der Figur nicht gezeigt.

Mit der erfindungsgemäßen Schaltung lassen sich Frequency Shift Keying (FSK) (beispielsweise GMSK, Standard-FSK, CPFSK) modulierte Signale mit kontinuierlichem Phasengang erzeugen. In der Figur ist der digitale Anteil im oberen Bereich und der analoge Anteil der Schaltung im unteren Bereich, getrennt durch eine gestrichelte Linie zu erkennen. Analog sind lediglich das analoge Filter H(s), der spannungsgesteuerte Oszillator VCO und die Endstufe PA ausgeführt.

Alle Komponenten innerhalb der gepunkteten Linie können auf einem Chip realisiert werden.

## Patentansprüche

1. Hochfrequenz-Signalgenerator,
bei dem ein spannungsgesteuerter Oszillator (VCO) zur Erzeugung eines Hochfrequenz-Signals vorgesehen ist,
bei dem ein Frequenzteiler (T) vorgesehen ist, welcher eingangsseitig mit dem spannungsgesteuerten Oszillator (VCO) verbunden ist und ausgangsseitig ein erstes Taktsignal liefert.
bei dem ein erster Akkumulator (ACCU1) vorgesehen ist, welcher vom ersten Taktsignal gesteuert ein erstes Referenzsignal (aRF) aufaddiert,
bei dem ein zweiter Akkumulator (ACCU2) vorgesehen ist, welcher von einem zweiten Taktsignal gesteuert, ein zweites Referenzsignal (aref) aufaddiert,
bei dem ein digitales Filter (H1(z)) vorgesehen ist, welches das Differenzsignal aus den beiden aufaddierten Referenzsignalen filtert,
bei dem ein Digital-Analog-Wandler (D/A) vorgesehen ist, der aus dem Ausgangssignal des ersten digitalen Filters (H1(z) ein Analogsignal erzeugt,
bei dem ein analoges Filter (H(s)) vorgesehen ist, welches das Analogsignal filtert, das dem spannungsgesteuerten Oszillator zugeführt wird.

2. Hochfrequenz-Signalgenerator nach Anspruch 1,
bei dem ein zweites digitales Filter (H2(z)) vorgesehen ist, welches ein Eingangssignal (ES) filtert,
bei dem ein Summierer (SUM) vorgesehen ist, welcher zwischen das erste digitale Filter (H1(z)), das zweite digitale Filter (H2(z)) und den Digital-Analog-Wandler (D/A) geschaltet ist.

3. Hochfrequenz-Signalgenerator nach Anspruch 1 oder 2,
bei dem eine Endstufe (PA) vorgesehen ist, die das Hochfrequenz-Signal verstärkt.

4. Hochfrequenz-Signalgenerator nach einem der Ansprüche 1 bis 3,
bei dem der Frequenzteiler (T) digital arbeitet und ein fest eingestelltes Teilerverhältnis (1/N) aufweist.

5. Hochfrequenz-Signalgenerator nach einem der Ansprüche 1 bis 4,
bei dem Mittel zur Gewichtung (MU1, MU2) der Ausgangssignale der digitalen Filter (H1(z), H2(z)) vorgesehen sind.

6. Hochfrequenz-Signalgenerator nach einem der Ansprüche 1 bis 5,
bei dem nach Einschwingen des spannungsgesteuerten Oszillators (VCO) das Analogsignal des Digital-Analog-Wandlers (D/A) konstant gehalten wird.

7. Hochfrequenz-Signalgenerator nach einem der Ansprüche 1 bis 6,
bei dem das erste digitale Filter (H1(z)) zeitabhängig adaptiv ausgeführt ist.

8. Hochfrequenz-Signalgenerator nach einem der Ansprüche 1 bis 7,
bei dem das analoge Filter (H(s)) als Dezimationsfilter mit gleichzeitiger Überabtastung ausgeführt ist.

9. Hochfrequenz-Signalgenerator nach einem der Ansprüche 2 bis 8,
bei dem zwischen den Summierer (SUM) und dem Digital-Analog-Wandler (D/A) ein drittes digitales Filter vorgesehen ist.

## Claims

1. Radio-frequency signal generator in which a voltage-controlled (VCO) for producing a radio-frequency signal is provided,
in which a frequency divider (T) is provided, whose input is connected to the voltage-controlled oscillator (VCO) and whose output supplies a first clock signal,
in which a first accumulator (ACCU1) is provided, which aggregates a first reference signal (aRF) under the control of the first clock signal,
in which a second accumulator (ACCU2) is provided, which aggregates a second reference signal (aref) under the control of a second clock signal,
in which a digital filter (H1(z)) is provided, which filters the different signal obtained from the two aggregated reference signals,
in which a digital-analog converter (D/A) is provided, which produces an analog signal from the output signal from the first digital filter (H1(z)),
and in which an analog filter (H(s)) is provided, which filters the analog signal fed to the voltage-controlled oscillator.

2. Radio-frequency signal generator according to Claim 1, in which a second digital filter (H2(z)) is provided, which filters an input signal (ES), and in which a adder (SUM) is provided, which is connected between the first digital filter (H1(z)), the second digital filter (H2(z)) and the digital-analog converter (D/A).

3. Radio-frequency signal generator according to Claim 1 or 2, in which an output stage (PA) is provided, which amplifies the radio-frequency signal.

4. Radio-frequency signal generator according to one of Claims 1 to 3,
in which the frequency divider (T) operates digitally and has a permanently set division ratio (1/N).

5. Radio-frequency signal generator according to one of Claims 1 to 4,
in which means are provided for weighting (MU1, MU2) the output signals from the digital filters (H1(z), H2(z)).

6. Radio-frequency signal generator according to one of Claims 1 to 5,
in which, once the voltage-controlled oscillator (VCO) has reached the steady state, the analog signal from the digital-analog converter (D/A) is kept constant.

7. Radio-frequency signal generator according to one of Claims 1 to 6,
in which the first digital filter (H1(z)) is designed to be adaptive as a function of time.

8. Radio-frequency signal generator according to one of Claims 1 to 7,
in which the analog filter (H)(s)) is designed as a decimation filter with simultaneous oversampling.

9. Radio-frequency signal generator according to one of Claims 2 to 8,
in which a third digital filter is provided between the adder (SUM) and the digital-analog converter (D/A).

## Revendications

1. Générateur de signaux haute fréquence,
dans lequel il est prévu un oscillateur commandé par tension (VCO) pour la production d'un signal haute fréquence,
dans lequel il est prévu un diviseur de fréquence (T) qui est relié en entrée à l'oscillateur commandé par tension (VCO) et qui foumit en sortie un premier signal d'horloge,
dans lequel il est prévu un premier accumulateur (ACCU1) qui additionne un premier signal de référence (aRF) suivant la commande du premier signal d'horloge,
dans lequel il est prévu un deuxième accumulateur (ACCU2) qui additionne un deuxième signal de référence (aref) suivant la commande d'un deuxième signal d'horloge,
dans lequel il est prévu un filtre numérique (H1(z)) qui filtre le signal de différence à partir des deux signaux de référence cumulés,
dans lequel il est prévu un convertisseur numérique-analogique (D/A) qui produit un signal analogique à partir du signal de sortie du premier filtre numérique (H1(z)),
dans lequel il est prévu un filtre analogique (H(s)) qui filtre le signal analogique qui est envoyé à l'oscillateur commandé par tension.

2. Générateur de signaux haute fréquence selon la revendication 1,
dans lequel il est prévu un deuxième filtre numérique (H2(z)) qui filtre un signal d'entrée (ES),
dans lequel il est prévu un additionneur (SUM) qui est branché entre le premier filtre numérique (H1(z)), le deuxième filtre numérique (H2(z)) et le convertisseur numérique-analogique (D/A).

3. Générateur de signaux haute fréquence selon la revendication 1 ou 2,
dans lequel il est prévu un étage final (PA) qui amplifie le signal haute fréquence.

4. Générateur de signaux haute fréquence selon l'une des revendications 1 à 3,
dans lequel le diviseur de fréquence (T) travaille de façon numérique et a un rapport de diviseur (1/N) réglé fixe.

5. Générateur de signaux haute fréquence selon l'une des revendications 1 à 4,
dans lequel il est prévu des moyens pour la pondération (MU1, MU2) des signaux de sortie des filtres numériques (H1(z), H2(z)).

6. Générateur de signaux haute fréquence selon l'une des revendications 1 à 5,
dans lequel, après le phénomène transitoire de l'oscillateur commandé par tension (VCO), le signal analogique du convertisseur numérique-analogique (D/A) est maintenu constant.

7. Générateur de signaux haute fréquence selon l'une des revendications 1 à 6,
dans lequel le premier filtre numérique (H1(z)) est réalisé adaptatif en fonction du temps.

8. Générateur de signaux haute fréquence selon l'une des revendications 1 à 7,
dans lequel le filtre analogique (H(s)) est réalisé comme un filtre de décimation avec suréchantillonnage simultané.

9. Générateur de signaux haute fréquence selon l'une des revendications 2 à 8,
dans lequel un troisième filtre numérique est prévu entre l'additionneur (SUM) et le convertisseur numérique-analogique (D/A).
